# EUROPÄISCHE PATENTSCHRIFT

(11) **EP 3 244 483 B1**
(45) Veröffentlichungstag und Bekanntmachung des Hinweises auf die Patenterteilung: **21.08.2019**
(21) Anmeldenummer: 17166585.4
(22) Anmeldetag: 13.04.2017
(51) Int. Cl.: H01Q 1/24, H01Q 1/52, H05K 9/00

(54) **SCHIRMGEHÄUSE FÜR HF-ANWENDUNGEN**
SCREENED CASING FOR USE IN HF APPLICATIONS
BOÎTIER BLINDÉ POUR APPLICATIONS HF

(30) Priorität: 13.05.2016 DE 102016108867
(43) Veröffentlichungstag der Anmeldung: 15.11.2017
(73) Patentinhaber: KATHREIN SE, 83022 Rosenheim (DE)
(72) Erfinder: Langenberg, Jörg, 83026 Rosenheim (DE); Richter, Torsten, 83022 Rosenheim (DE); Mayer, Josef, 83233 Bernau am Chiemsee (DE)
(74) Vertreter: Nowack, Linda

(56) Entgegenhaltungen:
- EP-A1- 1 133 064
- GB-A- 2 345 209
- US-A- 5 633 786
- US-A1- 2012 068 906
- US-A1- 2013 070 819
- US-A1- 2014 016 293
- US-A1- 2014 104 114
- US-A1- 2014 268 598

## Beschreibung

Die Erfindung betrifft ein Schirmgehäuse für HF-Anwendungen, sowie einen Antennenstrahler und ein entsprechendes System.

Für Basisstationsantennen im Mobilfunkbereich hat sich eine phasenfeste Zusammenschaltung von zwei oder mehreren Strahlerkomponenten zu Strahlerblöcken bei gewissen Ausführungen durchgesetzt. Durch das Zusammenfassen von Strahlern zu festen Blöcken kann der Aufwand für das Speisenetzwerk reduziert werden, wodurch Kosten, aber auch Platzbedarf, Fertigungsaufwand sowie Masse der Gesamtantenne reduziert werden. Der häufigste Fall ist die Zusammenschaltung von zwei Strahlern zu einer Einheit. Während die Zusammenschaltung z.B. mit geeigneten Combinern und Koaxialkabeln in Form von Streifenleitungen in Luft grundsätzlich üblich und bei Frequenzbereichen unterhalb von 1,0 GHz nach wie üblich ist, hat sich in den letzten Jahren die Realisierung mit Hilfe von Leiterplatten als guter Ansatz für breitbandige und kostengünstige Lösungen, vor allem im Frequenzbereich von 1,0 GHz bis 4,0 GHz und darüber hinaus durchgesetzt.

Um ein oder mehrere Strahler mit den gewünschten elektrischen Signalen zu versorgen und über Transformationsstrukturen geeignete Eingangsimpedanzen an definierten Schnittstellen realisieren zu können, haben sich Leiterplatten in Microstrip-Technologie als guter Lösungsansatz erwiesen. An diesen Schnittstellen können Koaxialkabel oder andere Signalleitungen angebracht werden, die Bestandteil des Speisenetzwerks der Antenne sind.

Die übliche Realisierung von Strahlerblöcken mit Hilfe von Streifenleitungen (z.B. Microstrip) sieht so aus, dass die Leitungsstruktur der Leiterplatte mehr oder weniger in Richtung der Hauptstrahlrichtung der Antenne gerichtet ist, während die Massefläche der Leiterplatte zum Reflektor der Antenne weist, in der Regel aber von diesem durch einen elektrisch isolierenden Lack, eine Folie oder einen anderen dünnen Isolator kapazitiv getrennt ist. Durch diese offene Struktur der Leiterplatte auf der Strahlerseite der Antenne ergeben sich neben den gewünschten Eigenschaften auch Möglichkeiten für unerwünschte Wechselwirkungen der Leiterplatte mit den Strahlern sowie der sonstigen Umgebung wie etwa dem Reflektor oder anderen elektrisch leitenden Strukturen. Diese Wechselwirkungen können negative Auswirkungen zeigen, da gewisse Antennenparameter in störender Weise beeinflusst werden und eine Kompensation kaum oder nur in gewissen Grenzen mit erhöhtem Aufwand möglich ist.

Um unerwünschte Wechselwirkungen von offenen Leiterplatten-Strukturen oder generell von offenen Leiterstrukturen zu vermeiden, werden in der Elektrotechnik üblicherweise Schirmungen bzw. Schirmgehäuse verwendet. Abschirmdeckel oder Schirmgehäuse in unterschiedlichen Ausführungsformen kommen gegen störende Hochfrequenz-Einstrahlung bzw. Abstrahlung auf oder von elektrischen Schaltkreisen bzw. offenen Leiterstrukturen zum Einsatz. Unerwünschte Beeinflussungen zwischen verschiedenen Komponenten in einem System, z.B. einer Antenne, können so vermieden werden.

Die Funktion eines Schirmgehäuses ist dann erfüllt, wenn in den Arbeits- bzw. Frequenzbereichen der zu schirmenden Leiterplatten bzw. des (Antennen-) Systems eine möglichst hohe Schirmdämpfung erreicht wird. Schirmgehäuse sind in der Elektrotechnik in unterschiedlichsten Ausführungen weit verbreitet und auch in der Antennen- und Filtertechnik sind verschiedene Ansätze zu finden.

Im Stand der Technik werden bereits Schirmungen vorgeschlagen, z.B. in der US2013070819A1, der US2012068906A1, der EP1133064A1, der GB2345209A, der US2014104114A1, der US2014268598A1, der US2014016293A1 oder der US5633786A.

Aufgabe dieser Erfindung ist es, eine Schirmung für Einzelstrahler oder einen Strahlerblock mit mindestens zwei Dipolen unter Verwendung einer offenen Leiterstruktur bereitzustellen, bei der störende Wechselwirkungen zwischen der Leiterstruktur und den Strahlern sowie der sonstigen Antenne vermieden werden.

Diese Aufgabe wird erfindungsgemäß durch die Merkmale der unabhängigen Patentansprüche gelöst. Vorteilhafte Ausgestaltungen sind Gegenstand der abhängigen Ansprüche.

Vorgeschlagen wird erfindungsgemäß ein Schirmgehäuse zur Abschirmung von auf einer Leiterplatte angeordneten Leitungsstrukturen und/oder Bauelementen, wobei auf dem Schirmgehäuse zumindest zwei Antennenstrahler mit zugehöriger Anspeisung angeordnet werden können, und wobei das Schirmgehäuse derart ausgebildet ist, dass es die auf der Leiterplatte angeordneten Leitungsstrukturen und/oder Bauelemente zumindest teilweise abdecken kann, mit einer Massefläche der Leiterplatte verbunden werden kann, und einen Bereich zwischen den Antennenstrahlern aufweist, der derart ausgebildet ist, dass er eine elektrische Entkopplung der Anspeisung der Antennenstrahler voneinander bereitstellt.

Die Oberseite des Schirmgehäuses wird als Deckel oder Schirmdeckel bezeichnet. Die Anordnung der Antennenstrahler auf der Oberseite des Schirmgehäuses, also dem Deckel wird später unter Bezugnahme auf die Figuren beschrieben.

In einer vorteilhaften Ausgestaltung ist das Schirmgehäuse derart ausgebildet ist, dass es die auf der Leiterplatte angeordneten Leitungsstrukturen und/oder Bauelemente vollständig abdecken kann.

In einer vorteilhaften Ausgestaltung ist eine Masse durch Durchkontaktierung zur Massefläche der Leiterplatte auf die Oberseite der Leiterplatte gezogen und das Schirmgehäuse ist direkt an der Oberseite mit der Masse kontaktierbar.

Durch die Abdeckung der Leiterplatte mit dem Schirmgehäuse und der gleichzeitigen Entkopplung der Antennenstrahler wird eine optimierte Abschirmung von HF-Komponenten gegen unerwünschte Einflüsse bzw. Wechselwirkungen erzielt.

Des Weiteren ist vorgesehen, dass der Bereich zwischen den Antennenstrahlern ein Bereich in der Mitte des Schirmgehäuses ist, der als eine Öffnung mit Umfalzungen um die Öffnung im Schirmgehäuse ausgebildet ist. Die Bereitstellung eines einstückigen Abschirmgehäuses mit in der Mitte befindlichen Umfalzung ermöglicht eine einfache und kostengünstige Herstellung des Gehäuses aus einem Stück.

In einer vorteilhaften Ausgestaltung sind an den Umfalzungen Anschlüsse bzw. Pins, die in einem vorgegebenen Pinabstand voneinander angeordnet sind, zur Kontaktierung der Leiterplatte angeordnet, wenn der Bereich in der Mitte des Schirmgehäuses als eine Öffnung mit Umfalzungen um die Öffnung im Schirmgehäuse ausgebildet ist.

Die Einhaltung eines vorgegebenen Pinabstands, welcher abhängig von den verwendeten Frequenzbereichen berechnet werden kann, gewährleistet eine optimale Schirmung.

Des Weiteren ist erfindungsgemäß vorgesehen, dass der Bereich zwischen den Anspeisungen der Antennenstrahler als eine mit Schirmgehäuse verbundene Trennwand ausgebildet ist, wenn kein Bereich in der Mitte des Schirmgehäuses als eine Öffnung mit Umfalzungen um die Öffnung im Schirmgehäuse ausgebildet ist.

In einer vorteilhaften Ausgestaltung ist die Trennwand mit dem Schirmgehäuse elektrisch kapazitiv oder galvanisch verbunden bzw. gekoppelt.

Die Bereitstellung eines einstückigen Abschirmgehäuses mit in der Mitte befindlicher elektrisch kapazitiv oder galvanisch gekoppelter Trennwand ist eine einfach herzustellende und kostengünstige Alternative zur Bereitstellung von Umfalzungen.

Des Weiteren kann in einer nicht beanspruchten Ausführung das Schirmgehäuse aus zwei Teilen bestehen, die in einem vorgegebenen Schirmgehäuseabstand voneinander auf der Leiterplatte angeordnet werden können.

Die Bereitstellung eines zweiteiligen Schirmgehäuses ist eine Alternative zu einem einstückig gebildeten Schirmgehäuse und weist dieselben Vorteile auf.

Des Weiteren ist erfindungsgemäß vorgesehen, dass das Schirmgehäuse an seinem äußeren Rand Anschlüsse bzw. Pins zur Kontaktierung der Massefläche der Leiterplatte aufweist, die in einem vorgegebenen Pinabstand voneinander angeordnet sind.

Durch die Bereitstellung von Pins in einem vorgegebenen Abstand kann eine zuverlässige und für die Schirmung optimierte Befestigung des Schirmgehäuses an der Leiterplatte bereitgestellt werden.

In einer vorteilhaften Ausgestaltung beträgt der vorgegebene Pinabstand 5 mm ≤ Abstand ≤ 15 mm. Dieser Pinabstand ist für die Verwendung im Frequenzbereich von 0,5 GHz bis 4,0 GHz vorteilhaft, um eine optimale Schirmung zu erzielen.

Des Weiteren ist erfindungsgemäß vorgesehen, dass das Schirmgehäuse Ausnehmungen zur Anordnung der zumindest zwei Antennenstrahler aufweist, wobei an einem Verbindungsbereich, an dem der Innenleiter jedes Antennenstrahlers mit der Leiterplatte verbunden wird, das Schirmgehäuse eine daraus tiefgezogene Struktur mit zumindest einem daran angeordneten Anschluss bzw. Pin zur Kontaktierung der Massefläche der Leiterplatte aufweist.

Durch das Bereitstellen einer tiefgezogenen Struktur am Schirmgehäuse kann eine direkte Verbindung des Antennenstrahlers mit der Massefläche erfolgen, ohne dass weitere Löcher auf der Oberseite des Schirmgehäuses benötigt werden.

Vorgesehen ist des Weiteren ein Antennenstrahler zur Anordnung auf einem oben beschriebenen Schirmgehäuse, wobei der Antennenstrahler eine Verlängerung seines Leitungssystems und zumindest einen Anschluss bzw. Pin aufweist, um mit der Massefläche der Leiterplatte kontaktiert zu werden.

Durch das Bereitstellen einer geeigneten Struktur am Antennenstrahler kann eine direkte Verbindung des Antennenstrahlers mit der Massefläche erfolgen, ohne dass weitere Löcher auf der Oberseite des Schirmgehäuses benötigt werden.

Vorgesehen ist im Rahmen der vorliegenden Erfindung des Weiteren ein System umfassend eine Leiterplatte und ein oben beschriebenes auf der Leiterplatte angeordnetes Schirmgehäuse, sowie einen oben beschriebenen Antennenstrahler, der auf der Leiterplatte angeordnet ist, wobei die Leiterplatte Ausnehmungen zur Hindurchführung aller mit der Leiterplatte zu kontaktierenden Pins und Strukturen aufweist. Ferner umfasst das System eine Adapterplatte, die auf der Seite der Leiterplatte angeordnet ist, welche dem Schirmgehäuse gegenüber liegt, und einen auf der Adapterplatte angeordneten Reflektor, wobei die Adapterplatte derart gebildet ist, dass sie an Stellen, an denen ein Anschluss bzw. Pin durch die Leiterplatte auf die Seite der Adapterplatte durchgeführt ist, über den Anschluss bzw. Pin ausgebuchtet ist, und der Reflektor an dieser Stelle eine Öffnung aufweist.

Vorgesehen ist im Rahmen der vorliegenden Erfindung des Weiteren ein System umfassend eine Leiterplatte und ein oben beschriebenes auf der Leiterplatte angeordnetes Schirmgehäuse, sowie einen oben beschriebenen Antennenstrahler, der auf der Leiterplatte angeordnet ist, wobei die Leiterplatte Ausnehmungen zur Hindurchführung aller mit der Leiterplatte zu kontaktierenden Pins und Strukturen aufweist. Ferner umfasst das System eine Adapterplatte, die auf der Seite der Leiterplatte angeordnet ist, welche dem Schirmgehäuse gegenüber liegt, und einen auf der Adapterplatte angeordneten Reflektor, wobei die Adapterplatte derart gebildet ist, dass sie eine Mindestdicke aufweist, die einer Länge des längsten durch die Leiterplatte auf die Seite der Adapterplatte durchgeführten Anschlüsse bzw. Pins entspricht und an Stellen, an denen ein Anschluss bzw. Pin durch die Leiterplatte auf die Seite der Adapterplatte durchgeführt ist, eine Öffnung aufweist.

Durch die Bereitstellung der Adapterplatte in den oben genannten Ausführungen können störende Einflüsse durch die Pins, die durch die Leiterplatte hindurchstehen, auf den Reflektor vermieden werden.

Weitere Merkmale und Vorteile der Erfindung ergeben sich aus der nachfolgenden Beschreibung von Ausführungsbeispielen der Erfindung, anhand der Figuren der Zeichnung, die erfindungsgemäße Einzelheiten zeigt, und aus den Ansprüchen. Die einzelnen Merkmale können je einzeln für sich oder zu mehreren in beliebiger Kombination bei einer Variante der Erfindung verwirklicht sein.

Bevorzugte Ausführungsformen der Erfindung werden nachfolgend anhand der beigefügten Zeichnung näher erläutert.
Fig. 1 zeigt eine Darstellung eines Schirmgehäuses gemäß einer Ausführung der vorliegenden Erfindung.
Fig. 2 zeigt eine Darstellung eines Schirmgehäuses gemäß einer weiteren Ausführung der vorliegenden Erfindung.
Fig. 3 zeigt eine Darstellung eines Schirmgehäuses gemäß einer weiteren Ausführung der vorliegenden Erfindung.
Fig. 4 zeigt eine Vergrößerung eines zusätzlichen Merkmals am Schirmgehäuse gemäß einer weiteren Ausführung der vorliegenden Erfindung.
Fig. 5 zeigt eine Darstellung eines Systems gemäß einer Ausführung der vorliegenden Erfindung.
Fig. 6 zeigt eine Darstellung eines Systems gemäß einer weiteren Ausführung der vorliegenden Erfindung.

In den nachfolgenden Figurenbeschreibungen sind gleiche Elemente bzw. Funktionen mit gleichen Bezugszeichen versehen.

Die Anordnung der Antennenstrahler auf dem Schirmgehäuse und der Leiterplatte hängt von der Anwendung ab. Im Mobilfunkbereich ist eine Realisierung von kombinierten Strahlern mit zwei orthogonal angeordneten Polarisationen üblich. Um die Anspeisung der beiden Polarisationen der Strahler elektrisch voneinander entkoppeln zu können, wurde das erfindungsgemäße Schirmgehäuse 1 entwickelt. Dieses Schirmgehäuse 1 kann in unterschiedlichen Ausgestaltungen dieselbe Wirkung erzielen.

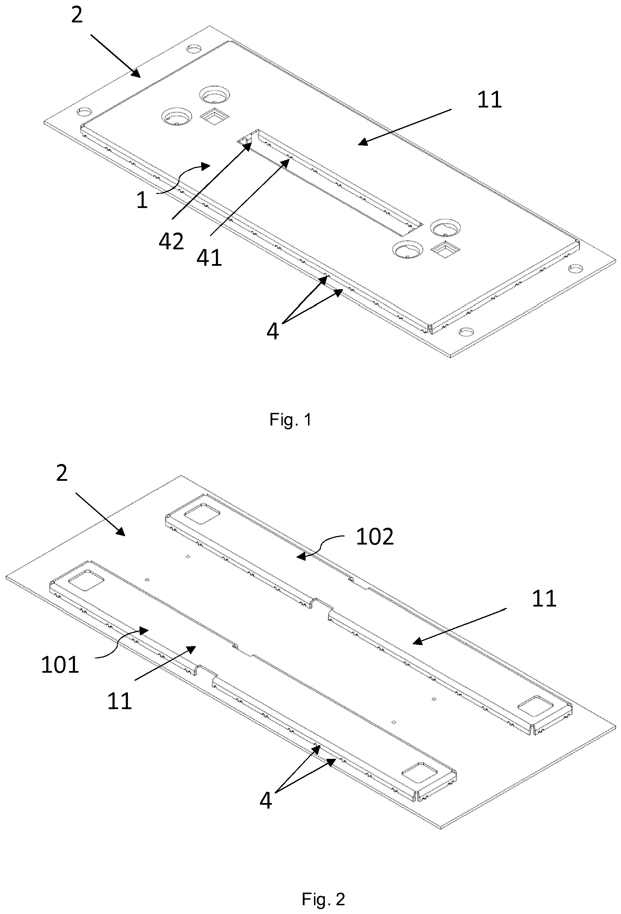

Fig. 1 zeigt ein Schirmgehäuse 1 gemäß einer Ausführung der vorliegenden Erfindung. Das Schirmgehäuse 1 kann auf einer Leiterplatte 2 derart angeordnet werden, dass es die auf der Leiterplatte 2 vorhandene offene Leiterstruktur sowie zusätzliche Bauteile/Komponenten nahezu vollständig, d.h. zumindest teilweise, bedeckt. Die für die Schirmung notwendige elektrische Verbindung zwischen dem Schirmgehäuse sowie der Massefläche der Leiterplatte 2 wird z.B. über Anschlüsse bzw. Pins 4 am Schirmgehäuse 1 realisiert. Die Pins 4 stehen durch die Leiterplatte 2 hindurch und sind auf der Unterseite der Leiterplatte 2 mit deren Massefläche elektrisch verbunden, z.B. verlötet. Die Oberseite des Schirmgehäuses 1 wird als Deckel oder Schirmdeckel 11 bezeichnet. Auf dem Deckel 11 sind Komponenten wie die Antennenstrahler 3 angeordnet.

Die Pins 4 sind in einem Abstand angeordnet, der geeignet ist, im gewünschten Frequenzbereich eine ausreichende Schirmwirkung zu erzielen. Für einen Frequenzbereich von 0,5 GHz bis 4,0 GHz liegen die Pinabstände bevorzugt zwischen 5 mm und 15 mm. Für höhere Frequenzen kann der Pinabstand noch weiter reduziert werden, um eine geeignete Schirmwirkung zu erzielen.

In Figur 1 ist eine bevorzugte Ausführung des Schirmgehäuses 1 gezeigt, nämlich als einstückig gebildetes Schirmgehäuse 1. Zur Entkopplung von zwei darauf anordenbaren Antennenstrahlern 3 wurde der Schirmdeckel 11 im mittleren Bereich zwischen den Antennenstrahlern 3 über einen Großteil seiner Länge aufgetrennt und umgefalzt. Zusätzliche Pins 41 an diesen umgefalzten Bereichen können nun ebenfalls mit der Massefläche auf der Unterseite der Leiterplatte 2 verbunden werden. Durch diese weitgehende Trennung der beiden Schirmdeckelbereiche ist eine ausreichend gute elektrische Isolationswirkung der Anspeisungen z.B. für zwei verschiedene Polarisationen zu erzielen. Weitere zusätzliche Pins 42 an den umgefalzten Stirnseiten des Schirmdeckels 11 erhöhen die erwünschte Isolationswirkung noch weiter.

Alternativ oder zusätzlich zu der Lösung, dass das einstückig gebildete Schirmgehäuse 1 eine Umfalzung umfasst, kann durch ein an dem Schirmgehäuse 1 angeordnetes Zusatzbauteil, z.B. in Form einer Trennwand im Schirmdeckel 11 eine ähnliche Wirkung erzielt werden. Dieses Zusatzbauteil kann mit dem Schirmdeckel 11 elektrisch verbunden oder galvanisch gekoppelt sein. Die Verbindung zur Massefläche der Leiterplatte 2 kann ebenfalls, wie oben beschrieben, über Pins oder auf andere Weise, z.B. kapazitiv oder galvanisch, erfolgen.

In Figur 2 ist ein Schirmgehäuse 1 gezeigt, das aus zwei Teilen besteht. In beiden Fällen können die vorher und nachfolgend beschriebenen Erweiterungen und Komponenten für beide Arten von Schirmgehäusen 1 verwendet werden. Leichte Modifikationen, um eine Anpassung an ein einstückiges Schirmgehäuse 1 oder ein Schirmgehäuse 1 aus zwei Teilen zu erhalten, ergeben sich für den Fachmann von selbst oder aus der nachfolgenden Beschreibung.

Bei einem aus zwei Teilen gebildeten Schirmgehäuse 1, wie in Figur 2 gezeigt, werden die beiden Teile 101 und 102 des Schirmgehäuses 1 in einem Abstand derart zueinander auf der Leiterplatte 2, bevorzugt mit ihren langen Seiten parallel zueinander bzw. nebeneinander, angeordnet, dass die nötige Schirmwirkung bereitgestellt wird. Dabei können die Teile 101 und 102 des Schirmgehäuses 1 derart ausgebildet sein, dass ein Teil jedes Antennenstrahlers 3 auf jeweils einem Teil 101 bzw. 102 des Schirmgehäuses 1 bzw. dem entsprechenden Deckel 11 angeordnet ist oder der gesamte Antennenstrahler 3 auf nur einem Teil 101 bzw. 102 des Schirmgehäuses 1 bzw. dem entsprechenden Deckel 11 angeordnet ist. Die Teile 101 und 102 des aus zwei Teilen bestehenden Schirmgehäuses 1 können in unterschiedlichster Form gebildet sein, solange sie die offenen Strukturen der Leiterplatte 2 nahezu vollständig bedecken, die Antennenstrahler 3 darauf angeordnet werden können und die gewünschte Schirmwirkung erzielt wird.

Wie für Figur 1 beschrieben können die beiden Teile 101 und 102 des Schirmgehäuses 1 an einer oder mehreren Außenseiten bzw. umlaufenden Seiten Pins 4 und/oder 41 aufweisen, durch welche die Isolationswirkung deutlich erhöht wird. Auch kann ein Teil 101 bzw. 102 oder beide Teile 101 und 102 des Schirmgehäuses 1 eine an dem jeweiligen Teil 101 bzw. 102 angeordnete Trennwand anstatt der Pins 4 aufweisen.

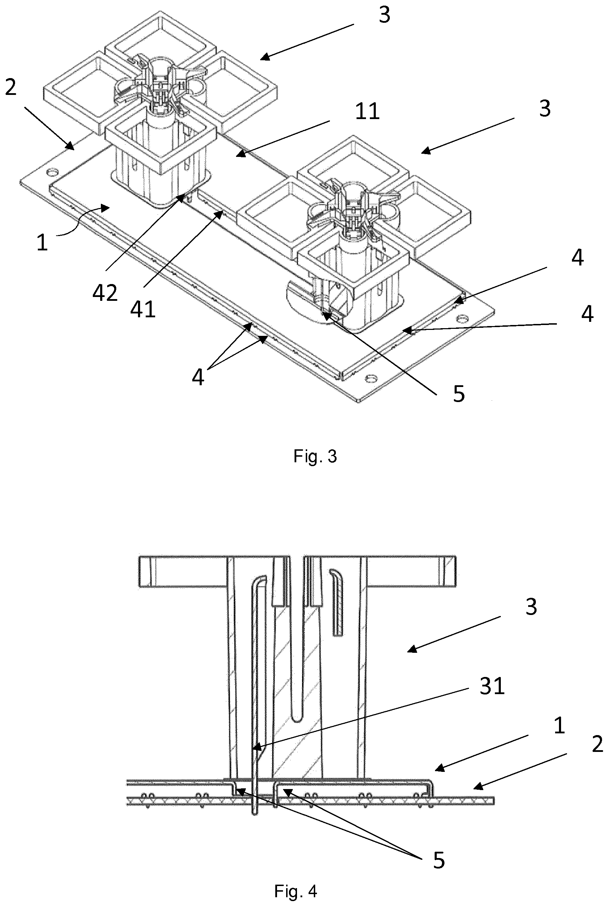

Figur 3 zeigt als ein Beispiel ein auf einer Leiterplatte 2 angeordnetes Schirmgehäuse 1 mit zwei darauf angeordneten Antennenstrahlern 3, in diesem Fall zwei Vektorstrahlern, gemäß einer Ausführung der vorliegenden Erfindung. Das Schirmgehäuse 1 ist einstückig ausgebildet und weist sowohl an seinen Außenseiten als auch an den Umfalzungen und der Stirnseite der Umfalzung Pins 4, 41, 42 auf. Zusätzlich ist ein in Figur 4 vergrößert dargestelltes weiteres Merkmal einer weiteren Ausführung der Erfindung zur Verbesserung der Schirmeigenschaften gezeigt, nämlich dass das Schirmgehäuse 1 einen tiefgezogenen Bereich aufweist, an dem über einen Pin ein elektrischer Kontakt 3 mit der Massefläche der Leiterplatte 2 hergestellt werden kann.

Die auf dem Schirmdeckel des Schirmgehäuses 1 angeordneten Antennenstrahler 3 sind hier als Vektorstrahler dargestellt, können aber auch andere geeignete Strahler, wie z.B. Kreuzdipole auf Blech- oder Leiterplattenbasis, Patchstrahler etc, sein, die auf der Leiterplatte 2 angeordnet werden.

Zur deutlichen Reduzierung der Masse bzw. des Gewichts der gesamten Antenne bzw. Baugruppe können Kunststoffstrahler mit durch z.B. Metallisierung hergestellter leitfähiger Oberfläche verwendet werden.

Die Massefläche der Antennenstrahler 3 wird beispielsweise kapazitiv über einen Isolator wie einen Lack, eine Kunststofffolie oder sonstige nicht leitende Oberflächen auf dem Dipol und/oder dem Schirmdeckel 11 an den Schirmdeckel 11 gekoppelt. Neben der kapazitiven Kopplung der Strahler 3 an das Schirmgehäuse 1 ist auch eine galvanische Anbindung durch Verschrauben, Anlöten, Einpressen und andere bekannte Verfahren möglich.

Alternativ zur Verwendung von Pins 4 zur Herstellung der optimalen elektrischen Verbindung zwischen Schirmgehäuse 1 und Massefläche der Leiterplatte können auch andere Arten der Verbindung verwendet werden. Beispielsweise können Durchkontaktierungen bzw. Vias an der Leiterplatte 2 angeordnet sein oder geeignete kapazitive Kopplungen bereitgestellt werden.

Durch das Schirmgehäuse 1 können nicht nur offene elektrische Leiterstrukturen auf der Leiterplatte abgedeckt werden, es können vielmehr auch zusätzliche Strukturen oder Bauteile abgedeckt werden, wie z.B. Filter in Microstrip-Technik oder Phasenschieberkomponenten. Wenn sich beispielsweise eine Filterstruktur unterhalb des Schirmgehäuses 1 befindet, können Abstimmelemente zu Abstimmung der Filtereigenschaften direkt in das Schirmgehäuse 1 eingelassen sein.

Zur Optimierung der Schirmwirkung kann vorgesehen sein, dass eine Anbindung von koaxialen Signalleitungen auf der Masseseite der Leiterplatte derart erfolgt, dass sowohl der Außenleiter als auch der Innenleiter der Antennenstrahler 3 nur von einer Seite verlötet werden. Durch diese Ausführung werden keine Öffnungen im Schirmdeckel 11 des Schirmgehäuses 1 benötigt. Das heißt, dass die Masse durch Durchkontaktierung zur Massefläche der Leiterplatte auf die Oberseite der Leiterplatte gezogen und das Schirmgehäuse und/oder einer oder mehrere des zumindest einen Deckels direkt an der Oberseite mit der Masse kontaktiert.

Durch die Ausführung des Schirmgehäuses 1 ist es möglich, ein sehr flaches Schirmgehäuse von nur 3 mm Höhe - ohne Pins - zu realisieren, wobei hierdurch die Diagramm-Eigenschaften des Antennenstrahlers 3 nicht oder nur geringfügig, d.h. in akzeptablem Rahmen, beeinflusst werden.

Fig. 4 zeigt eine vergrößerte Darstellung des in Figur 3 gezeigten weiteren Merkmals einer weiteren Ausführung der Erfindung zur Verbesserung der Schirmeigenschaften. Entscheidend für eine elektrisch gut ausgeführte Anbindung der auf den Schirmdeckeln 11 angeordneten Antennenstrahlern 3 an die Leiterplatte 2 ist es, eine elektrische Verbindung der signalführenden Strukturen zu ermöglichen, die mit einer möglichst geringen räumlichen Ausdehnung umgesetzt werden. In Figur 4 ist eine solche Anordnung gezeigt. Der Innenleiter 31 des Antennenstrahlers 3 ist derart verlängert, dass eine direkte Verbindung zur Leiterplatte 2 beispielsweise über eine Lötverbindung erfolgt. Die Masseverbindung wird erzielt, indem eine über den Schirmdeckel 11 tiefgezogene Struktur 5, an der ein oder mehrere Pins 43 angebracht sind, bereitgestellt wird.

Wie für die oben beschriebenen Pins ist auch für die Pins 43 der tiefgezogenen Struktur eine Verbindung mit der Massefläche durch Anlöten möglich. Die Pins 43 können wie die Pins 4, 41 und 42 durch die Leiterplatte 2 an dafür bereitgestellten Löchern in der Leiterplatte 2 auf die Unterseite der Leiterplatte 2 hindurchstehen.

Wenn die tiefgezogene Struktur 5 rund ausgeführt ist, bildet sie gewissermaßen eine Verlängerung des Koaxialsystems des Antennenstrahlers 3.

Alternativ zu der im Deckel vorhandenen tiefgezogenen Struktur 5 kann diese auch als Teil des Antennenstrahlers 3 bereitgestellt werden. Hier müssen dann entsprechende Pins oder andere geeignete Strukturen zur galvanischen oder kapazitiven Kontaktierung mit der Massefläche der Leiterplatte 2 bereitgestellt werden. Ferner muss in der Leiterplatte 2 ein genügend großes Loch bereitgestellt werden, so dass die Struktur am Antennenstrahler 3 durch die Leiterplatte 2 hindurchgeführt werden kann.

Eine Alternative zur tiefgezogenen Struktur im Schirmdeckel oder dem Antennenstrahler ist es, ein nicht beanspruchtes Adapter- oder Zusatzbauteil als Verbindungselement kapazitiv oder galvanisch an das Schirmgehäuse 1 oder der Antennenstrahler 3 zu koppeln. Die Verbindung mit der Massefläche der Leiterplatte 2 erfolgt dann ebenfalls über Pins oder andere geeignete Strukturen, wie oben besch rieben.

Durch diese Ausführungen können gute elektrische Werte beispielsweise für die Anpassung der Antennenstrahler und damit der gesamten Baugruppe erzielt werden. Zudem kann durch die direkte Verbindung der verlängerten Koaxialsysteme mit der Masse der Leiterplatte eine sehr gute Entkopplung der Polarisation erreicht werden.

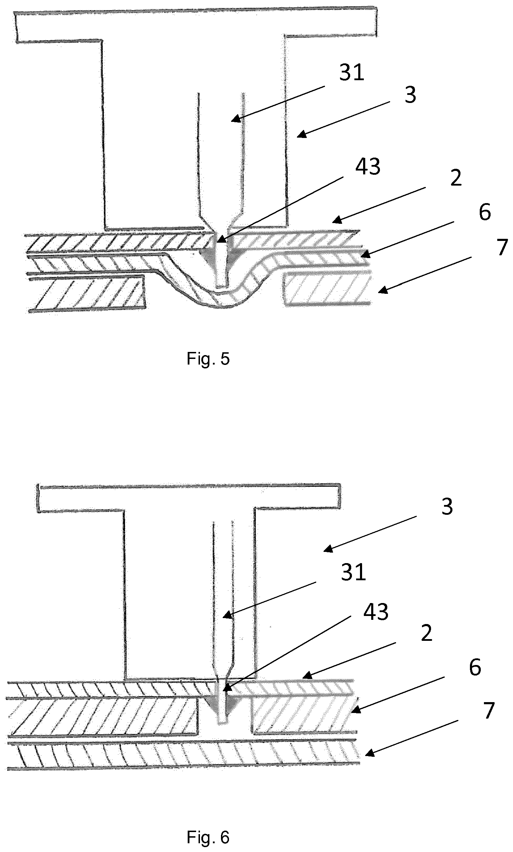

Eine weitere Optimierung der Schirmung kann erfolgen, indem die die durch die Leiterplatte 2 durchstehenden Pins 4, 41, 42, 43 auf der Rückseite der Leiterplatte 2 durch eine Adapterplatte 6 vom unterhalb der Leiterplatte 2 angeordneten Reflektor 7 abgeschirmt werden, wie in Figuren 5 und 6 gezeigt.

Figur 5 zeigt eine Ausführung, wie die durch die Leiterplatte 2 durchstehenden Pins 4, 41, 42, 43 auf der Rückseite der Leiterplatte 2 mittels einer Adapterplatte 6 abgeschirmt werden. Hierbei ist die Adapterplatte 6 derart über der Unterseite der Leiterplatte 2 angeordnet, dass sie an Stellen, an denen Pins 4, 41, 42, 43 durch die Leiterplatte hindurchstehen, eine Ausbuchtung aufweist. Der unterhalb der Adapterplatte 6 angeordnete Reflektor 7 weist an diesen Stellen eine Ausnehmung bzw. Öffnung auf, so dass die Ausbuchtung der Adapterplatte 6 genügend Platz hat. Durch diese Lösung werden die Eigenschaften des Reflektors nicht beeinträchtigt und unerwünschte Störungen durch die Pins 4, 41, 42, 43 werden vermieden.

Eine Alternative zu der oben genannten Lösung ist in Figur 6 gezeigt. Hier ist ebenfalls eine Adapterplatte 6 zwischen Leiterplatte 2 und Reflektor 7 bereitgestellt. Die Adapterplatte 6 ist in dieser Ausführung allerdings derart ausgebildet, dass sie eine Dicke aufweist, die mindestens der Länge des am weitesten durch die Leiterplatte durchstehenden Pins 4, 41, 42, 43 entspricht. Durch diese Dickenvorgabe kann der Reflektor 7 über die gesamte Unterseite der Leiterplatte gebildet werden, d.h. es müssen keine Löcher in das Reflektorblech 7 gebohrt werden, so dass keine störenden Einflüsse auf den Reflektor wirken.

Die Adapterplatte 6 in beiden Ausführungen kann durch ausreichend dünne Folien und/oder Lack und/oder geeignete Beschichtungen elektrisch isoliert sein, so dass eine kapazitive Kopplung zwischen Massefläche der Leiterplatte 2 und dem Reflektor 7 ermöglicht werden kann.

Die vorliegende Erfindung mit ihren Abwandlungen stellt eine vollständig geschirmte Anbindung von Antennenstrahlern an eine Leiterplatte und ein Reflektorblech zur Verfügung, wodurch unerwünschte Wechselwirkungen zwischen Anspeisung sowie Antennenstrahlern und der sonstigen Umgebung vermieden werden können. Dadurch können störende Einflüsse auf die Antennenparameter vermieden werden.

Außerdem können zusätzliche Funktionen oder Baugruppen wie Filter oder Phasenschieber ohne negative Wechselwirkungen mit den Antennenstrahlern bzw. der sonstigen Umgebung unterhalb des Schirmgehäuses integriert werden. Auch können weitere Funktionen, die bisher auf der Rückseite des Reflektors angeordnet waren, auf der Oberseite der Leiterplatte unter dem Schirmgehäuse bereitgestellt werden. Zusätzlich können im Schirmdeckel weitere Funktionen wie Abstimmelemente für Filter integriert werden.

Aufgrund der Ausführung des Schirmgehäuses können kapazitiv gekoppelte Antennenstrahler verwendet werden, so dass keine galvanische Verbindung wie Schraubkontakte oder Lötverbindungen und keine Löcher mehr in dem Schirmgehäuse benötigt werden. Auch ist durch die kapazitive Kopplung die Verwendung von Kunststoffstrahlern mit leitender Oberfläche möglich, so dass damit das Gesamtgewicht der Baugruppe vermindert werden kann.

### Bezugszeichenliste

- 1: Schirmgehäuse
- 11: Deckel
- 101, 102: Teile des Schirmgehäuses
- 2: Leiterplatte
- 3: Antennenstrahler
- 31: Innenleiter
- 4,41,42,43: Pins
- 5: tiefgezogene Struktur
- 6: Adapterplatte
- 7: Reflektor

## Patentansprüche

1. Schirmgehäuse (1) zur Abschirmung von auf einer Leiterplatte (2) angeordneten Leitungsstrukturen und/oder Bauelementen,
wobei auf dem Schirmgehäuse (1, 11) zumindest zwei Antennenstrahler (3) mit zugehöriger Anspeisung angeordnet werden können,
und wobei das Schirmgehäuse (1) derart ausgebildet ist, dass es
- die auf der Leiterplatte (2) angeordneten Leitungsstrukturen und/oder Bauelemente zumindest teilweise abdecken kann,
- mit einer Massefläche der Leiterplatte (2) verbunden werden kann, und
- einen Bereich zwischen den Antennenstrahlern (3) aufweist, der derart ausgebildet ist, dass er eine elektrische Entkopplung der Anspeisung der Antennenstrahler (3) voneinander bereitstellt,
- wobei der Bereich zwischen den Antennenstrahlern (3) ein Bereich in der Mitte des Schirmgehäuses (1, 11) ist, der als eine Öffnung mit Umfalzungen um die Öffnung im Schirmgehäuse (1, 11) ausgebildet ist, und/oder
- wobei das Schirmgehäuse (1, 11) Ausnehmungen zur Anordnung der zumindest zwei Antennenstrahler (3) aufweist, wobei an einem Verbindungsbereich, an dem der Innenleiter jedes Antennenstrahlers (3) mit der Leiterplatte (2) verbunden wird, das Schirmgehäuse (1) eine daraus tiefgezogene Struktur (5) mit zumindest einem daran angeordneten Pin (43) zur Kontaktierung der Massefläche der Leiterplatte (2) aufweist.

2. Schirmgehäuse (1) nach Anspruch 1, wobei das Schirmgehäuse (1) einstückig ausgebildet ist.

3. Schirmgehäuse (1) nach einem der Ansprüche 1 oder 2, wobei das Schirmgehäuse (1) derart ausgebildet ist, dass es die auf der Leiterplatte (2) angeordneten Leitungsstrukturen und/oder Bauelemente vollständig abdecken kann.

4. Schirmgehäuse (1) nach einem der Ansprüche 1 bis 3, wobei an den Umfalzungen Pins (41, 42), die in einem vorgegebenen Pinabstand voneinander angeordnet sind, zur Kontaktierung der Leiterplatte (2) angeordnet sind, wenn der Bereich in der Mitte des Schirmgehäuses (1, 11) als eine Öffnung mit Umfalzungen um die Öffnung im Schirmgehäuse (1, 11) ausgebildet ist.

5. Schirmgehäuse (1) nach einem der Ansprüche 1 bis 3, wobei der Bereich zwischen den Anspeisungen der Antennenstrahler (3) als eine mit dem Schirmgehäuse (1, 11) verbundene Trennwand ausgebildet ist, wenn kein Bereich in der Mitte des Schirmgehäuses (1, 11) als eine Öffnung mit Umfalzungen um die Öffnung im Schirmgehäuse (1, 11) ausgebildet ist.

6. Schirmgehäuse (1) nach Anspruch 5, wobei die Trennwand mit dem des Schirmgehäuse (1, 11) elektrisch kapazitiv oder galvanisch verbunden bzw. gekoppelt ist.

7. Schirmgehäuse (1) nach einem der vorhergehenden Ansprüche, wobei das Schirmgehäuse (1) an seinem äußeren Rand Pins (4) zur Kontaktierung der Massefläche der Leiterplatte (2) aufweist, die in einem vorgegebenen Pinabstand voneinander angeordnet sind.

8. Schirmgehäuse (1) nach Anspruch 4 oder 7, wobei der vorgegebene Pinabstand 5 mm ≤ Abstand ≤ 15 mm beträgt.

9. Schirmgehäuse (1) nach einem der Ansprüche 1 bis 3, wobei wenn keine tiefgezogene Struktur vorhanden ist und eine Masse durch Durchkontaktierung zur Massefläche der Leiterplatte (2) auf eine Oberseite der Leiterplatte (2) gezogen ist, das Schirmgehäuse (1) direkt an der Oberseite mit der Masse kontaktierbar ist.

10. System, umfassend
- eine Leiterplatte (2),
- ein auf der Leiterplatte (2) angeordnetes Schirmgehäuse (1) nach einem der Ansprüche 1 bis 8,
- einen Antennenstrahler (3), der eine Verlängerung seines Leitungssystems und zumindest einen Pin aufweist, um nach Montage mit der Massefläche der Leiterplatte (2) kontaktiert zu werden, wobei der Antennenstrahler (3) auf der Leiterplatte (2) angeordnet ist, wobei die Leiterplatte (2) Ausnehmungen zur Hindurchführung aller mit der Leiterplatte (2) zu kontaktierenden Pins und Strukturen aufweist, und
- eine Adapterplatte (6), die auf der Seite der Leiterplatte (2) angeordnet ist, welche dem Schirmgehäuse (1) gegenüber liegt, und
- einen auf der Adapterplatte (6) angeordneten Reflektor (7),
wobei die Adapterplatte (6) derart gebildet ist, dass sie an Stellen, an denen ein Pin (4, 41, 42, 43) durch die Leiterplatte (2) auf die Seite der Adapterplatte (6) durchgeführt ist, über den Pin (4, 41, 42, 43) ausgebuchtet ist, und der Reflektor (7) an dieser Stelle eine Öffnung aufweist.

11. System, umfassend
- eine Leiterplatte (2),
- ein auf der Leiterplatte (2) angeordnetes Schirmgehäuse (1) nach einem der Ansprüche 1 bis 8,
- einen Antennenstrahler (3), der eine Verlängerung seines Leitungssystems und zumindest einen Pin aufweist, um nach Montage mit der Massefläche der Leiterplatte (2) kontaktiert zu werden, wobei der Antennenstrahler (3) auf der Leiterplatte (2) angeordnet ist,
wobei die Leiterplatte (2) Ausnehmungen zur Hindurchführung aller mit der Leiterplatte (2) zu kontaktierenden Pins und Strukturen aufweist, und
- eine Adapterplatte (6), die auf der Seite der Leiterplatte (2) angeordnet ist, welche dem Schirmgehäuse (1) gegenüber liegt, und
- einen auf der Adapterplatte (6) angeordneten Reflektor (7),
wobei die Adapterplatte (6) derart gebildet ist, dass sie eine Mindestdicke aufweist, die einer Länge des längsten durch die Leiterplatte (2) auf die Seite der Adapterplatte (6) durchgeführten Pins (4, 41, 42, 43) entspricht und an Stellen, an denen ein Pin (4, 41, 42, 43) durch die Leiterplatte (2) auf die Seite der Adapterplatte (6) durchgeführt ist, eine Öffnung aufweist.

## Claims

1. A shield housing (1) for shielding interconnect structures and/or components disposed on a circuit board,
wherein at least two antenna radiators (3) with corresponding feed can be disposed on the shield housing (1, 11), and
wherein the shield housing (1) is configured in such a manner that it can cover the interconnect structures and/or components disposed on the circuit board (2), at least in part,
- can be connected with a ground surface of the circuit board (2), and has a region between the antenna radiators (3), which is configured in such a manner that it provides electrical decoupling of the feed of the antenna radiators (3) from one another,
wherein the region between the antenna radiators (3) is a region in the center of the shield housing (1, 11), which region is configured as an opening having folded areas around the opening in the shield housing (1, 11), and/or
wherein the shield housing (1, 11) has recesses for placement of the at least two antenna radiators (3), wherein the shield housing (1) has a structure that is deep-drawn from it, having at least one pin (43) disposed on it for contacting the ground surface of the circuit board (2) in a connecting region in which the inner conductor of each antenna radiator (3) is connected with the circuit board (2).

2. The shield housing (1) according to claim 1, wherein the shield housing is configured in one piece.

3. The shield housing (1) according to claim 1 or 2, wherein the shield housing (1) is configured in such a manner that it can completely cover the interconnect structures and/or components disposed on the circuit board (2).

4. The shield housing (1) according to any one of claims 1 to 3, wherein pins (41, 42), which are disposed at a predetermined pin distance from one another, are disposed at the folded areas for contacting the circuit board (2) in case that the center of the shield housing (1, 11) is configured as an opening having folded areas around the opening in the shield housing (1, 11).

5. The shield housing (1) according to any one of claims 1 to 3, wherein the region between the feeds of the antenna radiators (3) is configured as a partition wall connected with the shield housing (1, 11), in case that no region in the center of the shield housing (1, 11) is configured as an opening having folded areas around the opening in the shield housing (1, 11).

6. The shield housing (1) according to claim 5, wherein the partition wall is electrically connected or capacitively or galvanically coupled with the shield housing (1, 11).

7. The shield housing (1) according to any one of the preceding claims, wherein the shield housing (1) has pins (4) for contacting the ground surface of the circuit board (2) on its outer edge, which pins are disposed at a predetermined pin distance from one another.

8. The shield housing (1) according to claim 7, wherein the predetermined pin distance amounts to 5 mm ≤ distance ≤ 15 mm.

9. The shield housing according to any one of claims 1 to 3, wherein in case no deep-drawn structure is provided and a ground is drawn to the ground surface of the circuit board (2) on the top of the circuit board by means of through-contacting, and the shield housing (1) can be contacted with the ground directly on the top.

10. A system, comprising
A circuit board (2),
a shield housing (1) according to any one claims 1 to 8 arranged on the circuit board (2),
an antenna radiator (3), which comprises an extension of its line system and at least one pin so as to be contacted to the ground of the circuit board (2) after assembly, wherein the antenna radiator (3) is disposed on a circuit board (2), wherein the circuit board has (2) recesses for passing through all the pins and structures to be contacted with the circuit board (2), and
an adapter plate (6), which is disposed on the side of the circuit board (2) that lies opposite the shield housing (1), and
a reflector (7) disposed on the adapter plate (6),
wherein the adapter plate (6) is configured in such a manner that it bulges outward above the pin (4, 41, 42, 43) at locations where a pin (4, 41, 42, 43) is passed through the circuit board (2) to the side of the adapter plate (6), and the reflector (7) has an opening at this location.

11. A system, comprising
A circuit board (2),
a shield housing (1) according to any one claims 1 to 8 arranged on the circuit board (2),
an antenna radiator (3), which comprises an extension of its line system and at least one pin so as to be contacted to the ground of the circuit board (2) after assembly, wherein the antenna radiator (3) is disposed on a circuit board (2), wherein the circuit board has (2) recesses for passing through all the pins and structures to be contacted with the circuit board (2), and
an adapter plate (6), which is disposed on the side of the circuit board (2) that lies opposite the shield housing (1), and
a reflector (7) disposed on the adapter plate (6),
wherein the adapter plate (6) is configured in such a manner that it has a minimum thickness that corresponds to a length of the longest pin (4, 41, 42, 43) passed through the circuit board (2) to the side of the adapter plate (6), and has an opening at locations where a pin (4, 41, 42, 43) is passed through the circuit board (2) to the side of the adapter plate (6).

## Revendications

1. Boîtier blindé (1) destiné au blindage de structures conductrices et/ou de composants agencés sur une plaque conductrice (2),
dans lequel au moins deux radiateurs d'antenne (3) dotés d'une alimentation rattachée peuvent être arrangés sur le boîtier blindé (1, 11),
et le boîtier blindé (1) étant conçu de telle sorte
- qu'il peut recouvrir au moins partiellement les structures conductrices et/ou les composants agencés sur la plaque conductrice (2),
- qu'il peut être connecté à un plan de masse de la plaque conductrice (2), et
- qu'il comporte une zone entre les radiateurs d'antenne (3), laquelle est conçue de telle sorte qu'elle crée un découplage électrique des alimentations des radiateurs d'antenne (3) l'une par rapport à l'autre,
- dans lequel la zone entre les radiateurs d'antenne (3) est une zone au milieu du boîtier blindé (1, 11), laquelle est conçue comme une ouverture dotée de pliages autour de l'ouverture dans le boîtier blindé (1, 11), et/ou
- le boîtier blindé (1, 11) comportant des évidements destinés à agencer les au moins deux radiateurs d'antenne (3), sur une zone de connexion, où le conducteur interne de chaque radiateur d'antenne (3) est raccordé à la plaque conductrice (2), le boîtier blindé (1) comportant une structure emboutie dans celui-ci (5) dotée d'au moins une broche (43) agencée dans celle-ci pour entrer en contact avec le plan de masse de la plaque conductrice (2) .

2. Boîtier blindé (1) selon la revendication 1, le boîtier blindé (1) étant conçu d'une seule pièce.

3. Boîtier blindé (1) selon l'une des revendications 1 et 2, le boîtier blindé (1) étant conçu de telle sorte qu'il peut entièrement recouvrir les structures conductrices et/ou les composants agencés sur la plaque conductrice (2).

4. Boîtier blindé (1) selon l'une des revendications 1 à 3, dans lequel des broches (41, 42), qui sont agencées avec un écart de broche prédéfini l'une par rapport à l'autre, sont agencées aux pliages pour entrer en contact avec la plaque conductrice (2), lorsque la zone au milieu du boîtier blindé (1, 11) est conçue comme une ouverture dotée de pliages autour de l'ouverture dans le boîtier blindé (1, 11).

5. Boîtier blindé (1) selon l'une des revendications 1 à 3, dans lequel la zone entre les alimentations des radiateurs d'antenne (3) est conçue comme paroi de séparation raccordée au boîtier blindé (1, 11), lorsqu'il n'y pas de zone au milieu du boîtier blindé (1, 11) conçue comme une ouverture dotée de pliages autour de l'ouverture dans le boîtier blindé (1, 11).

6. Boîtier blindé (1) selon la revendication 5, dans lequel la paroi de séparation est connectée ou couplée électriquement au boîtier blindé (1, 11) de manière capacitive ou galvanique.

7. Boîtier blindé (1) selon l'une des revendications précédentes, le boîtier blindé (1) comportant sur son bord extérieur des broches (4) entrant en contact avec le plan de masse de la plaque conductrice (2), lesquelles sont agencées avec un écart de broche prédéfini l'une par rapport à l'autre.

8. Boîtier blindé (1) selon la revendication 4 ou 7, dans lequel l'écart de broche prédéfini vaut 5 mm ≤ écart ≤ 15 mm.

9. Boîtier blindé (1) selon l'une des revendications 1 à 3, dans lequel lorsqu'aucune structure emboutie n'est présente et qu'une masse est tirée, à travers une interconnexion traversante jusqu'au plan de masse de la plaque conductrice (2), sur une face supérieure de la plaque conductrice (2), le boîtier blindé (1) pouvant entrer en contact avec la masse directement sur la face supérieure.

10. Système, comprenant
- une plaque conductrice (2),
- un boîtier blindé (1) agencé sur la plaque conductrice (2) selon l'une des revendications 1 à 8,
- un radiateur d'antenne (3), lequel comporte une prolongation de son système conducteur et au moins une broche, afin d'entrer en contact avec le plan de masse de la plaque conductrice (2), dans lequel le radiateur d'antenne (3) est agencé sur la plaque conductrice (2), dans lequel la plaque conductrice (2) comporte des évidements destinés au guidage de toutes les broches et structures devant entrer en contact avec la plaque conductrice (2), et
- une plaque d'adaptation (6), laquelle est agencée sur le côté de la plaque conductrice (2) situé contre le boîtier blindé (1), et
- un réflecteur (7) agencé sur la plaque d'adaptation (6), dans lequel la plaque d'adaptation (6) est formée de telle sorte qu'elle est creusée, aux endroits où une broche (4, 41, 42, 43) traverse la plaque conductrice (2) sur le côté de la plaque d'adaptation (6), au-dessus de la broche (4, 41, 42, 43), et le réflecteur (7) comporte une ouverture à cet endroit.

11. Système, comprenant
- une plaque conductrice (2),
- un boîtier blindé (1) agencé sur la plaque conductrice (2) selon l'une des revendications 1 à 8,
- un radiateur d'antenne (3), lequel comporte une prolongation de son système conducteur et au moins une broche, afin d'entrer en contact avec le plan de masse de la plaque conductrice (2), dans lequel le radiateur d'antenne (3) est agencé sur la plaque conductrice (2), dans lequel la plaque conductrice (2) comporte des évidements destinés au guidage de toutes les broches et structures devant entrer en contact avec la plaque conductrice (2), et
- une plaque d'adaptation (6), laquelle est agencée sur le côté de la plaque conductrice (2) situé contre le boîtier blindé (1), et
- un réflecteur (7) agencé sur la plaque d'adaptation (6), dans lequel la plaque d'adaptation (6) est formée de telle sorte qu'elle présente une épaisseur minimale correspondant à une longueur de la broche (4, 41, 42, 43) la plus longue traversant la plaque conductrice (2) sur le côté de la plaque d'adaptation (6) et comporte une ouverture aux endroits auxquels une broche (4, 41, 42, 43) traverse la plaque conductrice (2) sur le côté de la plaque d'adaptation (6).
